# EUROPEAN PATENT APPLICATION

(11) **EP 2 474 372 A2**
(43) Date of publication of application: **11.07.2012**
(21) Application number: 12150561.4
(22) Date of filing: 10.01.2012
(51) Int. Cl.: B08B 17/06

(54) **Super-hydrophobic microstructure**

(30) Priority: 11.01.2011 TW 100100970
(71) Applicant: National Cheng Kung University, Tainan City 70101 (TW)
(72) Inventor: Lee, Sen-Yung, 701 Tainan City (TW); Liao, Shih-Kuei, 412 Taichung City (TW); Chen, Yen-Chun, 880 Magong City, Penghu County (TW)
(74) Representative: 2K Patentanwälte Blasberg Kewitz & Reichel

(57) **Abstract**

A super-hydrophobic microstructure includes a base body on which plural protrusions with different heights are formed. Some of the protrusions with different heights construct at least one closed curve from the top view. The super-hydrophobic microstructure has the advantages of higher structural strength and lower cost, and is easy to be manufactured.

## Description

### BACKGROUND OF THE INVENTION

### Field of Invention

The present invention relates to a microstructure and, in particular, to a super-hydrophobic microstructure.

### Related Art

In the Nature, plants are always exposed to various kinds of contaminants such as dusts, mud, or organics (e.g. bacteria or funguses). The leaves of some plants have inherent complex nano/micro structures for self-cleaning and preventing the infection by bacteria or pathogens. Once the leaves have been polluted, a big rain can surely wash the contaminants away, and the leaves are well cleaned. One of the famous examples is the lotus effect.

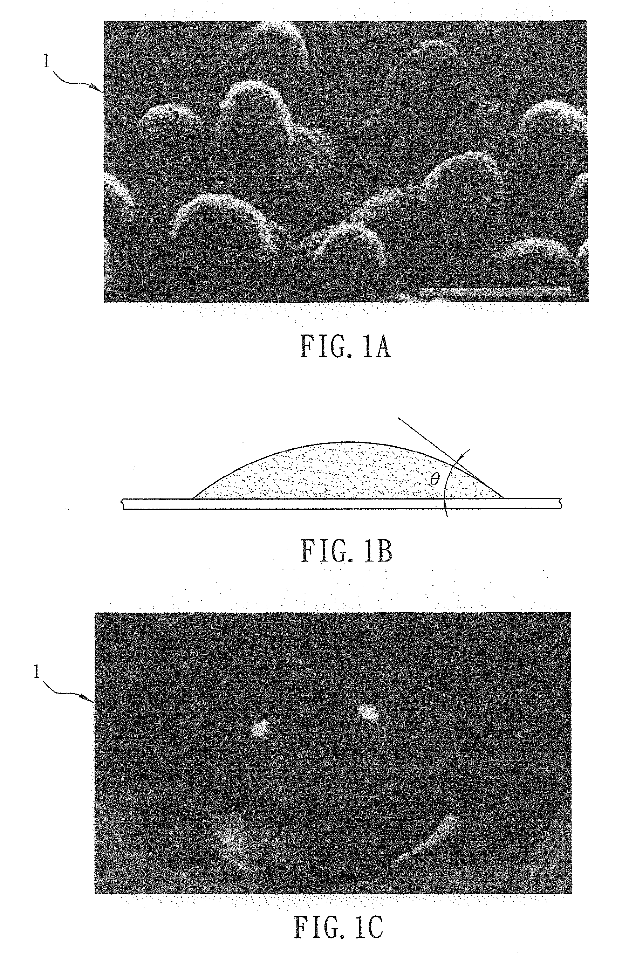

The lotus effect was disclosed by Germany botanists, Barthlott and Neinhuis, on 1997 when studying the lotus leaf phenomenon. They used an SEM (scanning electron microscope) to observe the surface 1 of a lotus leaf (as shown in FIG. 1A). It is discovered that the epidermal cell of the surface 1 includes 5-15 µm pillars, and a layer of wax crystal (about 100nm) covers the surface 1.

As shown in FIG. 1B, if the contact angle θ between a water droplet and a surface is smaller than 90 degrees, this surface is hydrophilic; otherwise, if the contact angle θ between a water droplet and a surface is greater than 90 degrees, this surface is hydrophobic. Moreover, if the contact angle θ between a water droplet and a surface is greater than 150 degrees, this surface is super-hydrophobic. In FIG. 1B, since the contact angle θ is smaller than 90 degrees, this surface is hydrophilic.

As shown in FIG. 1C, when a water droplet is disposed on the surface 1, a large contact angle θ can be provided by the surface 1, so that the water droplet forms a ball shape. In this case, the advancing contact angle θ between the water droplet and the surface 1 can be up to 150 degrees, which means the surface 1 of the lotus leaf is super-hydrophobic. Interestingly, if the surface 1 is slightly tilted, the water droplet may roll along the tilted surface 1 and thus carry the dust and mud particles away, thereby achieving the self-cleaning effect.

It is disclosed that the MEMS (micro-electro-mechanical system) can be applied to manufacture the hydrophobic material and structure on the surface of an object. In more detailed, the MEMS can imitate and configure the pillar structure of the lotus leaf. Accordingly, the MEMS can sufficiently increase the surface roughness so as to decrease the contact area between the water droplet and the object surface, thereby increasing the contact angle θ therebetween.

However, the simulated pillar microstructure made by MEMS still has the following drawbacks:

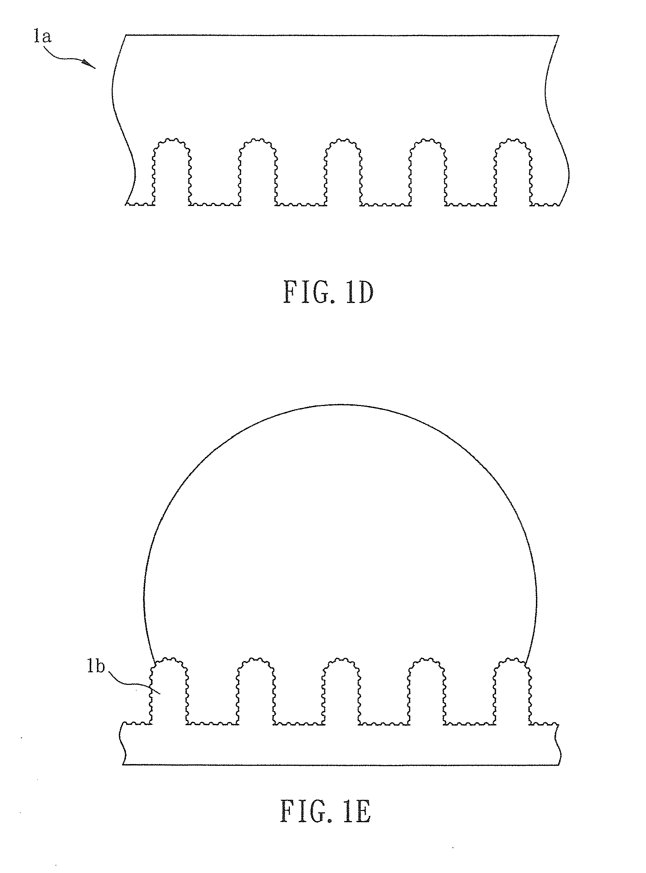

1. The pillar structure can not be easily manufactured so it is unable to be applied to mass production. The conventional method is to form rough surface or pillar structure on the material by MEMS technology. However, this method is only suitable for the laboratory research about the hydrophobic effect, but can not be applied to mass production. The mass production of the microstructure can be achieved by micro imprinting, and the mold 1a with the pattern of the rough surface or pillar structure is necessary as shown in FIG. 1D. Unfortunately, the mold 1a, which has a lot of micro-scaled holes, is hard to be prepared, and it certainly includes non-connected holes. Since the non-connected holes of the mold 1a usually contain air, the applied material can not fully fill the holes of the mold 1a during the imprinting process. Thus, the manufactured surface by imprinting may not fit the original design. In addition, the pattern of the mold that imitates the rough surface or pillar structure of the natural lotus leaf is not configured with the taper angle as the normal mold, so that the structure may be destroyed during the imprinting process.

2. The strength of the pillar structure is insufficient, so it may not survive from the additional processes. In general, the pillar structure can be easily broken as a slight lateral or vertical force is applied, and the super-hydrophobic effect is damaged too. Moreover, when the super-hydrophobic structure with the pillars is made as a thin film (like a sticker) and then fixed on the object surface, it is also need to apply force on the super-hydrophobic film. Due to the bad strength of the pillar structure, the super-hydrophobic film may not survive from additional processes, so the additional processes become impossible.

3. The pillar structure may lose its hydrophobic ability under some conditions. For example, a static water droplet standing on the rough or pillar structure surface may have the hydrophobic feature because the contact area between the water droplet and the structure surface is sufficiently decreased. However, if the pillar structure is an open structure, which allows the airflow in the pillars, the water droplet (falling from a high point to the pillar structure 1b) may push the air between the pillars out. This may wet the pillar structure 1b (see FIG. 1E) and cause the loss of hydrophobic ability thereof.

Therefore, it is an important subject of the present invention to provide a super-hydrophobic microstructure that has higher structural strength and lower cost, and is easy to be manufactured.

### SUMMARY OF THE INVENTION

In view of the foregoing subject, an objective of the present invention is to provide a super-hydrophobic microstructure that has higher structural strength and lower cost, and is easy to be manufactured.

To achieve the above objective, the present invention discloses a super-hydrophobic microstructure. The super-hydrophobic microstructure includes a base body, and a plurality of protrusions with different heights are formed on the base body. Some of the protrusions with different heights form at least one closed curve as viewing from the top view.

In one embodiment of the present invention, the protrusions comprises at least a first protrusion with a first height and at least a second protrusion with a second height, and the first height is greater than the second height.

In one embodiment of the present invention, the protrusions are long-shaped and connect with each other.

In one embodiment of the present invention, at least one of the protrusions has a breaking portion.

In one embodiment of the present invention, at least one of the protrusions has a linear shape, a curved shape or a bend-line shape.

In one embodiment of the present invention, the closed curve is polygonal, arc-shaped, circular, or irregular.

In one embodiment of the present invention, the base body is manufactured by nano/micro-imprint lithography.

In one embodiment of the present invention, the base body is flexible.

In addition, the present invention also discloses a super-hydrophobic microstructure for providing a super-hydrophobic function when a water droplet is disposed thereon. The super-hydrophobic microstructure includes a base body, and a plurality of protrusions with different heights are formed on a surface of the base body. When the water droplet contacts with the protrusions but does not contact with the surface, the water droplet and the protrusions form a closed space.

As mentioned above, the super-hydrophobic structure of the present invention has a base body configured with a plurality of protrusions with different heights, which form a closed curve as viewing from the top view. Accordingly, when a water droplet falls from a high point to the super-hydrophobic microstructure, the closed space formed by the water droplet and the protrusions can provide an air spring effect to bounce the water droplet away. Thus, the water droplet can not stay on the surface of the base body so as to achieve the super-hydrophobic effect of the invention. Besides, the protrusions with different heights can disperse the impact of the falling water droplet, so that the super-hydrophobic effect can be further enhanced.

In addition, the base body of the super-hydrophobic microstructure has the protrusions with different heights and the protrusions are connected, so that the mold for the imprinting process does not have the isolated holes. During the manufacturing by nano/micro-imprint lithography, the air contained inside the mold can be totally pushed out so as to fabricate the precise super-hydrophobic microstructure. In particular, this manufacturing method is suitable for mass production and can decrease the manufacturing cost. Besides, since the protrusions with different heights are connected and form a closed curve, the structural strength of the super-hydrophobic microstructure can be improved. Moreover, the protrusions with different heights can form multiple layers of closed spaces, so that it can provide multilayer air spring effect, which can further enhance the super-hydrophobic effect.

### BRIEF DESCRIPTION OF THE DRAWINGS

The invention will become more fully understood from the detailed description and accompanying drawings, which are given for illustration only, and thus are not limitative of the present invention, and wherein:

FIG. 1A is a picture of the surface of a lotus leaf observed by SEM;

FIG. 1B is a schematic diagram showing the contact angle while a water droplet rests on the surface of an object;

FIG. 1C is a picture of a water droplet resting on the surface of a lotus leaf;

FIG. 1D is a schematic diagram of a mold for pillar structure;

FIG. 1E is a schematic diagram of a water droplet resting on the pillar structure;

FIG. 2 is a schematic diagram of a super-hydrophobic microstructure according to a preferred embodiment of the present invention;

FIG. 3A is a top view of the super-hydrophobic microstructure of FIG. 2;

FIGS. 3B to 3D are top views of different aspects of the super-hydrophobic microstructure;

FIG. 4 is a schematic diagram showing a water droplet resting on a super-hydrophobic microstructure 2; and

FIGS. 5A to 5C are schematic diagrams showing different aspects of the super-hydrophobic microstructure of the present invention.

### DETAILED DESCRIPTION OF THE INVENTION

The present invention will be apparent from the following detailed description, which proceeds with reference to the accompanying drawings, wherein the same references relate to the same elements.

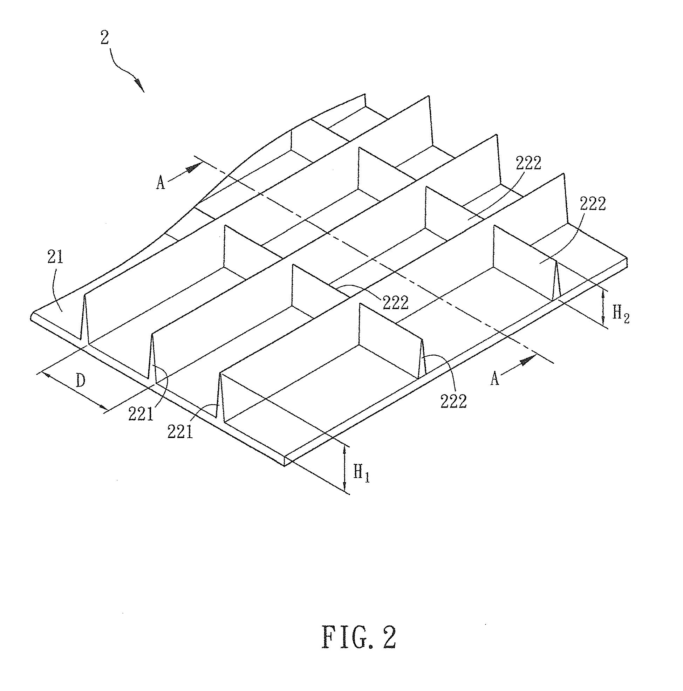

FIG. 2 is a schematic diagram of a super-hydrophobic microstructure 2 according to a preferred embodiment of the present invention. The super-hydrophobic microstructure 2 can be applied to buildings, daily-use articles, medical products, or electronic products for hydrophobic, water-proof, or anti-dust. For example, the super-hydrophobic microstructure 2 can be applied to the wall of buildings to provide water-proof and hydrophobic functions; it can also be applied to the urinal or toilet to prevent urine from remaining thereon; it can further be applied to the windscreen of vehicle to facilitate the water wiper; otherwise, it can be applied to the screen of mobile phone for provide water-proof function. In this invention, the application of the super-hydrophobic microstructure 2 is not limited. Besides, the method for disposed the super-hydrophobic microstructure 2 on the surface of an object is also not limited. For example, the super-hydrophobic microstructure 2 can be disposed on the surface of an object by adhering or attaching so as to provide the desired hydrophobic, water-proof, and anti-dust functions.

The super-hydrophobic microstructure 2 includes a base body 21. In this embodiment, the base body 21 can be integrally formed by nano/micro-imprint lithography, so it is suitable for mass production. The material of the base body 21 may include, for example, PDMS (poly-dimethylsiloxane), PMMA (poly-methylmethacrylate), PVC (polyvinylchloride), or PE (Polyethylene). In this case, the base body 21 is made of PDMS for example. To be noted, the base body 21 can be flexible. Besides, the super-hydrophobic microstructure 2 can be disposed on a planar object or a non-planar curved surface. Thus, the object with curved surface can be equipped with the hydrophobic, water-proof, and/or anti-dust function.

With reference to FIG. 2, a plurality of protrusions with different heights are formed on the base body 21, and the protrusions are long-shaped and connect with each other. Herein, at least one of the protrusions has a linear shape, a curved shape or a bend-line shape, and at least one of the protrusions has a breaking portion. In other words, while viewing from the top of the super-hydrophobic microstructure 2, the shape of the protrusion is a linear line, a curved line or a bend line. In addition, it is possible to configure several linear or curved lines between two protrusions, and the linear or curved lines can be totally or partially separated. Alternatively, the linear or curved lines may have a breaking portion and thus be discontinuous. To be noted, the base body 21 can also be a non-periodical and non-uniform structure.

The protrusions include at least a first protrusion 221 and at least a second protrusion 222. In this embodiment, the base body 21 includes a plurality of first protrusions 221 and a plurality of second protrusions 222. The first protrusion 221 has a first height H1 while the second protrusion 222 has a second height H2, and the first height H1 is greater than the second height H2. The first protrusions 221 are the highest protrusions on the base body 21, and their height is at least 10 µm. In this case, the height of the first protrusions 221 is 20 µm. The distance D between two first protrusions 221 is between 20 to 100 µm. In this case, the distance D between two first protrusions 221 is 35 µm. Besides, in order to make the manufacturing process more easier and increase the structural strength of the first protrusions 221 and the second protrusions 222, the first protrusions 221 and the second protrusions 222 may be formed with the cross-section shaped as trapezoid, square, rectangle, triangle, or curve. In this case, the cross-section of the first protrusions 221 and the second protrusions 222 is, for example but not limited to, trapezoid.

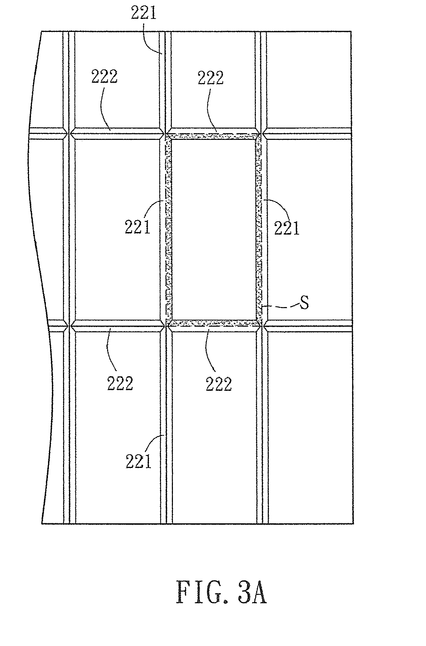

FIG. 3A is a top view of the super-hydrophobic microstructure 2 of FIG. 2. Referring to FIGS. 2 and 3A, the first protrusions 221 and the second protrusions 222 are all linear lines and connected with each other. Besides, the second protrusions 222 are interrupted by and first protrusions 221 and thus have breaking portions (discontinuous). Of course, it is possible to configure the breaking portions on the first protrusions 221. In this embodiment, the protrusions 221 and 222 with different heights can form at least one closed curve S as viewing from the top view. The closed curve S can be arc-shaped, circular, irregular, or polygonal (e.g. square, rectangular, normal hexangular (honey comb)). In this embodiment, the first protrusions 221 and the second protrusions 222 form a closed curve S, which is rectangular as shown in FIG. 3A.

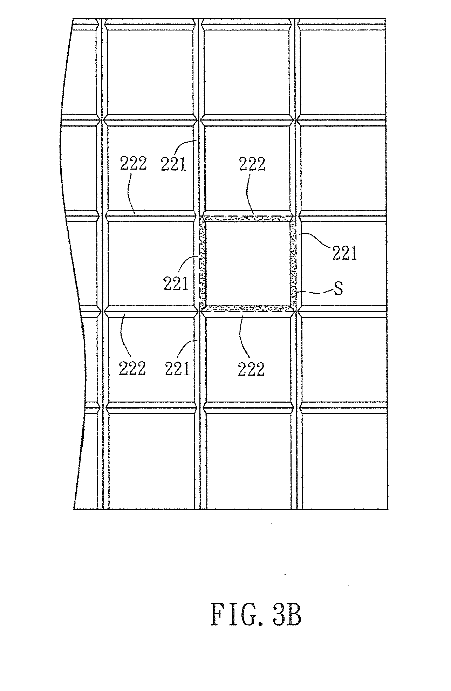

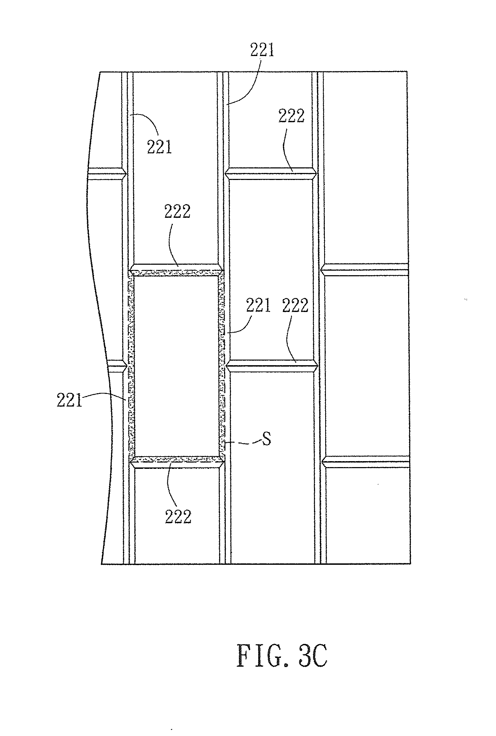

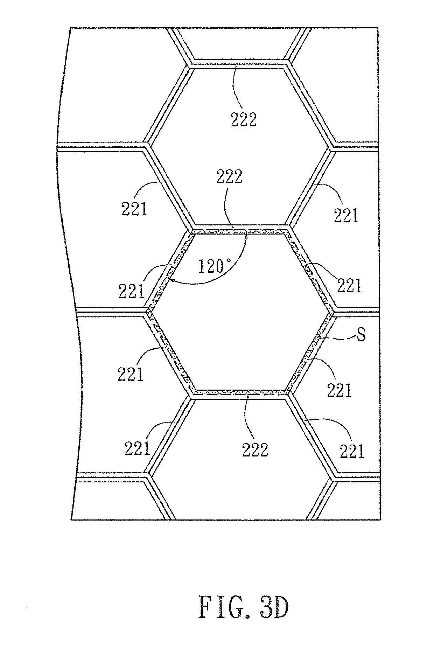

Alternatively, as shown in FIG. 3B, the first protrusions 221 and the second protrusions 222 form a closed curve S, which is square. As shown in FIG. 3C, the first protrusions 221 and the second protrusions 222 form a closed curve S, which is also rectangular. Although the closed curves S in FIGS. 3A and 3C are both rectangular, two ends of the second protrusion 222 of FIG. 3C are all cut by the first protrusions 221, and the second protrusion 222 does not extend to the other side of the connected first protrusions 221. As shown in FIG. 3D, the first protrusions 221 and the second protrusions 222 form a closed curve S, which is a honey comb. To be noted, the shape of the closed curve formed by the protrusions with different heights is not limited, and the most important condition is to form a closed curve by the protrusion as viewing from the top.

To be noted, regarding to the periodical patterns shown in FIGS. 3A to 3D, the region enclosed by the dotted lines of the closed curve represents the area of a single structure, and the solid fraction can be obtained by dividing the area defined between the dotted lines and the solid lines of the closed curve with the area of the single structure. In this case, the solid fraction is between 0 and 0.2.

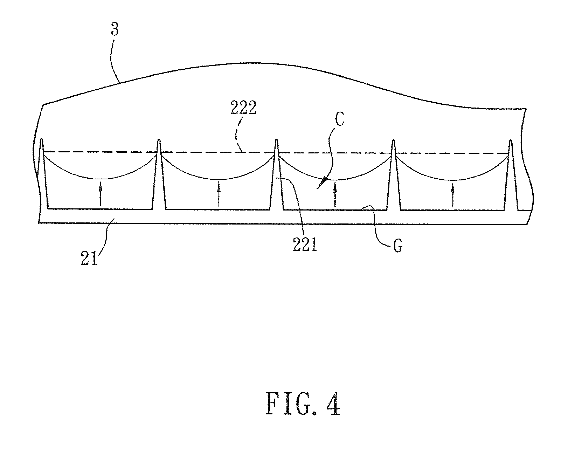

FIG. 4 is a sectional view showing a water droplet 3 resting on the super-hydrophobic microstructure 2 along the line A-A of FIG. 2.

As shown in FIG. 4, since the first protrusions 221 and the second protrusions 222 with different heights form the closed curve S as viewing from the top view, a recess portion can be configured by the first protrusions 221 and the second protrusions 222. In this case, the air inside the recess can not flow to other recess. When the water droplet 3 falls from a high point to contact with the protrusions 221 and 222 of the super-hydrophobic microstructure 2 but not contact with the surface G, the water droplet 3 firstly covers the recess configured by the closed curve S. Accordingly, the air inside the recess is compressed, and the water droplet 3 and the protrusions 221 and 222 form a closed space C. When the water droplet 3 reaches the lowest point, the air inside the closed space C, like a spring, can bounce the water droplet 3 out. This is called an air spring effect. In brief, when the water droplet 3 falls from a high point, the super-hydrophobic microstructure 2 can bounce the water droplet 3 out due to the air spring effect of the enclosed space C, so that no water droplet can stay on the surface of the super-hydrophobic microstructure 2.

It is proved that the contact angle of the super-hydrophobic microstructure 2 of the present invention is more than 150 degrees (about 160 degrees) so as to provide the super-hydrophobic effect. In addition, the rolling angle of the super-hydrophobic microstructure 2 is about 4 degrees, so that it is possible to roll the water droplets on the super-hydrophobic microstructure 2 by slightly tilting the super-hydrophobic microstructure 2. Moreover, the rolling water droplets can carry the dust and mud particles away, thereby achieving the self-cleaning effect.

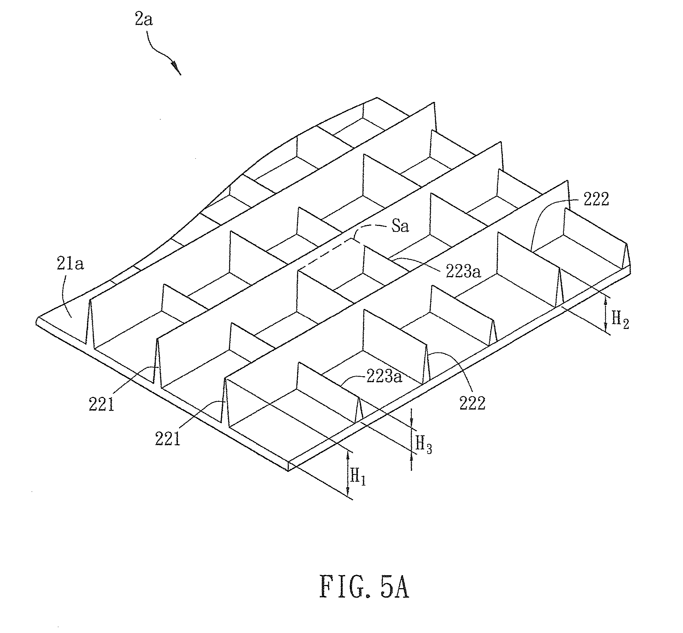

FIG. 5A is a schematic diagram showing a super-hydrophobic microstructure 2a which is another aspect of the present invention.

The difference between the super-hydrophobic microstructures 2a and 2 is in that the base body 21 a of the super-hydrophobic microstructure 2a further includes at least a third protrusion 223a. In this embodiment, the base body 21a includes a plurality of third protrusions 223a. The third protrusion 223a is disposed between two second protrusions 222, and the two ends of the third protrusion 223a are connected with the first protrusions 221. Besides, the third protrusion 223a has a third height H3, which is smaller than the second height H2 of the second protrusion 222.

In this embodiment, the third protrusion 223a is disposed between two second protrusions 222 and connected with the first protrusions 221. As viewing from the top, two first protrusions 221, one second protrusion 222 and one third protrusion 223a form another closed curve Sa. In other embodiment, the first protrusions 221 and the third protrusions 223a may form another closed curve; the second protrusions 222 and the third protrusions 223a may form another closed curve; otherwise, at least one first protrusion 221, at least one second protrusion 222 and at least one third protrusion 223a may form another closed curve.

The other technical features of the super-hydrophobic microstructure 2a are similar to those of the super-hydrophobic microstructure 2, so the detailed descriptions thereof will be omitted.

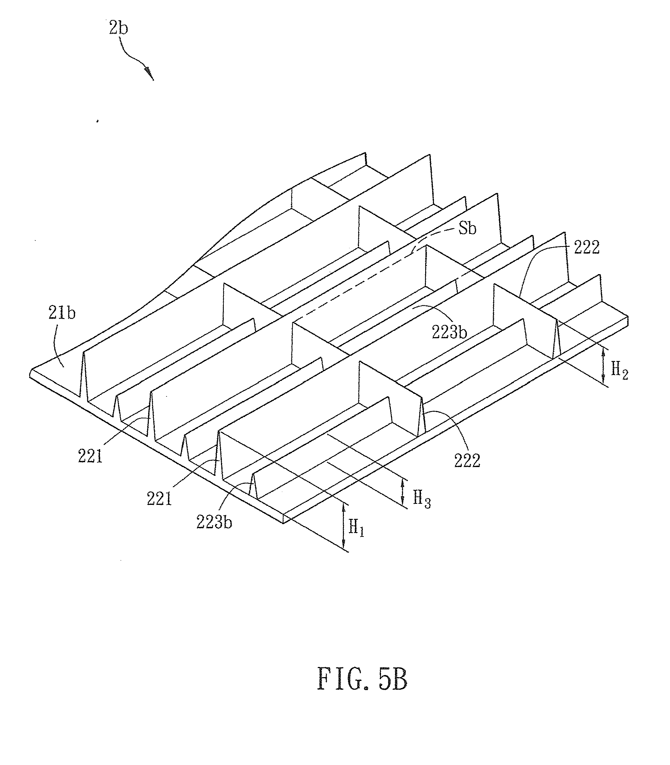

FIG. 5B is a schematic diagram showing a super-hydrophobic microstructure 2b which is another aspect of the present invention.

The difference between the super-hydrophobic microstructures 2b and 2a is in that each third protrusion 223a is disposed between two first protrusions 221, and two ends of the third protrusion 223a are connected with the second protrusions 222.

As shown in FIG. 5B, one first protrusion 221, two second protrusions 222 and one third protrusion 223b form another closed curve Sb.

The other technical features of the super-hydrophobic microstructure 2b are similar to those of the super-hydrophobic microstructures 2 and 2a, so the detailed descriptions thereof will be omitted.

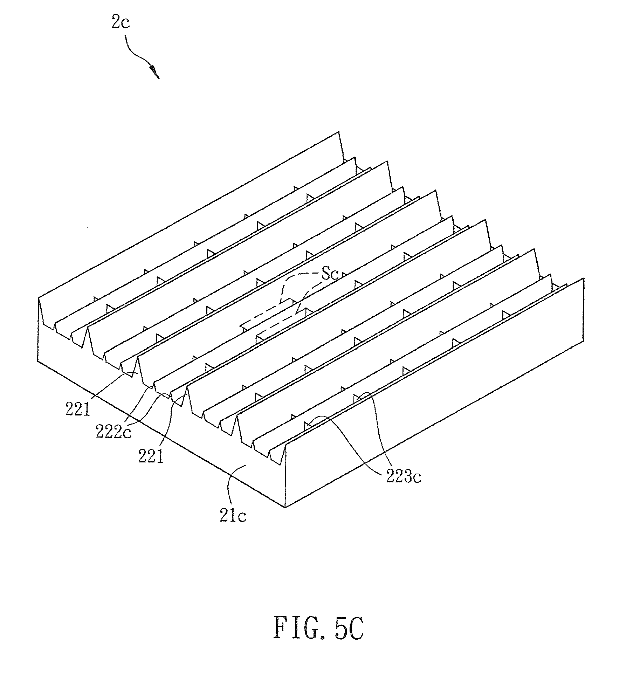

FIG. 5C is a schematic diagram showing a super-hydrophobic microstructure 2c which is another aspect of the present invention.

The difference between the super-hydrophobic microstructures 2c and 2b is in that two second protrusions 222c are disposed between adjacent two first protrusions 221, two ends of one third protrusion 223c are connected with the first protrusion 221 and the second protrusion 222c, respectively, and the two ends of another third protrusion 223c are connected with two second protrusions 222c. As viewing from the top, two second protrusions 222c and two third protrusions 223c form another closed curve Sc, and a first protrusion 221, a second protrusion 222c and two third protrusions 223c form another closed curve Sc.

The other technical features of the super-hydrophobic microstructure 2c are similar to those of the super-hydrophobic microstructures 2, 2a and 2b, so the detailed descriptions thereof will be omitted.

In summary, the super-hydrophobic structure of the present invention has a base body configured with a plurality of protrusions with different heights, which form a closed curve as viewing from the top view. Accordingly, when a water droplet falls from a high point to the super-hydrophobic microstructure, the closed space formed by the water droplet and the protrusions can provide an air spring effect to bounce the water droplet away. Thus, the water droplet can not stay on the surface of the base body so as to achieve the super-hydrophobic effect of the invention. Besides, the protrusions with different heights can disperse the impact of the falling water droplet, so that the super-hydrophobic effect can be further enhanced.

In addition, the base body of the super-hydrophobic microstructure has the protrusions with different heights and the protrusions are connected, so that the mold for the imprinting process does not have the isolated holes. During the manufacturing by nano/micro-imprint lithography, the air contained inside the mold can be totally pushed out so as to fabricate the precise super-hydrophobic microstructure. In particular, this manufacturing method is suitable for mass production and can decrease the manufacturing cost. Besides, since the protrusions with different heights are connected and form a closed curve, the structural strength of the super-hydrophobic microstructure can be improved. Moreover, the protrusions with different heights can form multiple layers of closed spaces, so that it can provide multilayer air spring effect, which can further enhance the super-hydrophobic effect.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A super-hydrophobic microstructure (2), comprising:
a base body (21), wherein a plurality of protrusions (221, 222) with different heights are formed on the base body, and some of the protrusions with different heights form at least one closed curve as viewing from a top view.

2. The super-hydrophobic microstructure of claim 1, wherein the protrusions comprises at least a first protrusion (221) with a first height (H1) and at least a second protrusion (222) with a second height (H2), and the first height is greater than the second height.

3. The super-hydrophobic microstructure of claim 1 or 2, wherein the protrusions are long-shaped and connect with each other.

4. The super-hydrophobic microstructure of any of the preceding claims, wherein at least one of the protrusions (221, 222) has a breaking portion.

5. The super-hydrophobic microstructure of any of the preceding claims, wherein at least one of the protrusions has a linear shape, a curved shape or a bend-line shape.

6. The super-hydrophobic microstructure of any of the preceding claims, wherein the closed curve is polygonal, arc-shaped, circular, or irregular.

7. The super-hydrophobic microstructure of any of the preceding claims, wherein the base body (21) is manufactured by nano/micro-imprint lithography.

8. The super-hydrophobic microstructure of any of the preceding claims, wherein the base body (21) is flexible.

9. A super-hydrophobic microstructure (2), optionally according to any of the preceding claims, for providing a super-hydrophobic function when a water droplet is disposed thereon, the super-hydrophobic microstructure comprising:
a base body (21), wherein a plurality of protrusions (221, 222) with different heights are formed on a surface of the base body, and when the water droplet contacts with the protrusions but does not contact with the surface, the water droplet and the protrusions form a closed space.
